# EUROPÄISCHE PATENTANMELDUNG

(11) **EP 2 527 290 A1**
(43) Veröffentlichungstag der Anmeldung: **28.11.2012**
(21) Anmeldenummer: 12153466.3
(22) Anmeldetag: 01.02.2012
(51) Int. Cl.: B81B 3/00, B81C 1/00

(54) **Halbleiterkomponente mit Mikrobrücken zur Einstellung eines Zugdehnungszustandes und Verfahren zu seiner Herstellung**

(30) Priorität: 24.05.2011 EP 11004279
(71) Anmelder: Paul Scherrer Institut, 5232 Villigen (CH); ETH Zürich, 8092 Zürich (CH)
(72) Erfinder: Sigg, Hans Christian, 8932 Mettmenstetten (CH); Süess, Martin, 8057 Zürich (CH); Schiefler, Gustav, 8002 Zürich (CH); Spolenak, Ralph, 8103 Unterengstringen (CH); Faist, Jérôme, 8052 Zürich (CH)
(74) Vertreter: Fischer, Michael

(57) **Zusammenfassung**

Die Erfindung ermöglicht das Einstellen eines Zugdehnungszustandes in Halbleiterkomponenten, ohne die Probleme des jetzigen Stands der Technik. Dazu wird eine vorverspannte (Zugdehnung)-Schicht auf einem Substrat aufgebracht (Figur 1, (A)). In diese Schichten werden Brückenstrukturen (Figur 1, (B)) mittels Lithographie und Ätzverfahren eingebracht. Diese Brücken sind an beiden Seiten mit der Schicht verbunden, und somit durchgängig. Ihre geometrische Struktur ist durch die Lithographie und durch das Ätzen charakterisierten Fenster (Figur 1, (C)) in der Schicht bestimmt. Die Brücken weisen eine Querschnittsmodulation auf. Wenn das Substrat selektiv geätzt wird, wird durch die Fenster die Brücke unterätzt. Die geometrische Strukturierung des Querschnitts (Figur 1, (D)) bewirkt eine Neuverteilung der ursprünglich homogenen Dehnung, sobald die auf diese Weise strukturierten Brücken vom Substrat gelöst werden. Dabei entspannen sich die Brückenteile mit großem Querschnitt auf Kosten der Teile mit kleinerem Querschnitt, in denen die Vorverspannung erhöht wird. Es ist zu beachten, dass nur Multiplikation von ursprünglich in der Probe vorhandenen Spannungen (resp. Dehnungen) möglich ist. Der Multiplikationsfaktor ist bestimmt durch Längen, Breiten und Tiefen, respektive deren Verhältnisse. Effektiv erfährt die Brücke eine Dehnung- resp. Spannungsmodulation durch Querschnittsmodulation, wobei lokale Entspannung und lokale Verspannungen aus der homogenen und "globalen" Vorverspannung resultieren (Figur 2). Beliebige lokale Erhöhungen und Erniedrigungen der Vorverspannung sind möglich, und das Modulationsprofil der Dehnung entlang der Brücke hängt nur von der Vorverspannung, der Geometrie und des Grades der Unterätzung ab.

## Beschreibung

Die vorliegende Erfindung bezieht sich auf eine Halbleiterkomponente mit Mikrobrücken zur Einstellung eines Zugdehnungszustandes und ein Verfahren zu seiner Herstellung.

Elektronische Apparate, wie z.B. Computer, sind aus verschiedenen Gründen von zentraler Bedeutung. Der Zuwachs an Rechenleistung, bei gleichzeitiger Größen- und Gewichtsabnahme, welcher seit der Entwicklung des Transistors zu beobachten war, ist als Moore'sches Gesetz bekannt. In den letzten Jahren ist eine Abweichung von diesem Gesetz hin zu geringerem Wachstum in der Rechenleistung zu beobachten. Zu den vielversprechendsten Ansätzen für die weitere Erhöhung zählt man die Verspannung von Silizium, womit die Beweglichkeit der Ladungsträger verbessert und die Kombination von Elektronik mit Photonik ermöglicht wird.

Letzteres ermöglicht die Kommunikation zwischen den sogenannten "Cores" von Multicore-Prozessoren, auf welchen das Wachstum der Rechenleistung in den letzten Jahren oft beruhte, untereinander mit Licht zu regeln. Dazu benötigt man verschiedene optische Komponenten und Schaltelemente, einige davon sind auch schon realisiert, wie zum Beispiel Wellenleiter, Detektoren und auch Modulatoren basierend auf Ladungsträger-Injektion. Woran es derzeit noch fehlt, ist ein mit der etablierten Silizium-basierten Elektronik kompatibles Material zum Senden von optischen Impulsen zwecks Informationsübertragung. So basiert zum Beispiel eine Laserlichtquelle auf der Rekombination von Elektronen im Leitungsband mit zugehörigen Lochzuständen im Valenzband. Es fehlen aber auch schnelle optische Modulatoren, die auf Empfängern nicht-linearer Licht-Generierung basieren. Letztere Methode ermöglicht beispielsweise die Signale zweier verschiedener optischer Kanäle zu verbinden.

Silizium ist bekanntlich ein Material mit indirekter Bandlücke und die Kopplung mit Photonen (Licht) ist schwach. Daher sind die vorgängig genannten optischen Bauelemente, der sogenannte Interband Laser wie auch schnelle Modulatoren auf Basis vom Stark-Effekt nicht realisiert worden. Die Symmetrie von unverspanntem Silizium verbietet auch die nicht-lineare Lichtkopplung. Ähnliche Einschränkungen gelten auch für Germanium, wie auch für alle Materialen, die aus der Mischung zwischen Silizium und Germanium (SiₓGe₁-ₓ) entstehen.

Das Besondere an Germanium im Vergleich zum Silizium ist hingegen, dass optische Anregungen (der inverse Prozess zur vorstehend genannten Rekombination) vom Valenz zum Leitungsband trotz der indirekten Bandlücke sehr effizient sind. Das direkte Leitungsband, das sogenannte Gamma-Minimum, befindet sich energetisch gesehen gerade mal etwa 20% oberhalb vom indirekten, dem sogenannten L-Minimum. Effiziente Detektoren können daher in Germanium realisiert werden; um jedoch einen effizienten auf Ladungsträgerrekombination basierenden Laser zu bauen, wäre eine direkte Bandlücke von Nöten.

Theoretische Betrachtungen und Berechnungen sagen nun voraus, dass Germanium ab einem bestimmten Zugdehnungsgrad tatsächlich eine direkte Bandlücke aufweist und sich somit als Laser-Material eignen könnte. Der Grad der benötigten Zugdehnung hängt von der Art der Beanspruchung, der kristallographischen Ausrichtung, sowie dem der Berechnung zugrunde liegenden Modell ab. Germanium als Vertreter der vierten Hauptgruppe weist die gleiche Kristallstruktur, und ähnliche chemische Eigenschaften auf wie Silizium, und ist deshalb ein Kandidat für die monolithische Integration in die vorherrschende Silizium-Technologie.

Bis jetzt gelang es jedenfalls nicht, Germanium genügend auf Zug zu verspannen, um eine direkte Bandlücke zu erzeugen. Allerdings ist Lasing in Germanium gezeigt worden, wobei die fehlende Zugverspannung durch n-Dotierung kompensiert wurde.

Zugverspannung führt aber nicht nur bei Germanium zu neuen Anwendungen, sondern es wurde auch voraus gesagt, dass die elektrischen Eigenschaften im Silizium durch geeignete Verspannung verbessert werden können. Dies gilt im Besonderen für n-dotiertes Silizium, wo Zugsverspannung zu einer dramatischen Mobilitätssteigerung führen könnte. Auch hier, wie beim Germanium gilt, dass entsprechende Verspannungs-Werte noch nicht erreicht werden konnten.

Die vorliegende Erfindung stellt einen Mechanismus bereit, und dessen Nutzung, welcher die genaue Einstellung eines Zugdehnungszustandes in vor-verspannten Germanium, oder einem anderen vor-verspannten Material, zum Beispiel Silizium, einschließlich Schichtsystemen, mittels Strukturierung und Mikroprozessierung ermöglicht. Von besonderer Bedeutung ist dabei der planare Aufbau, welcher die Anwendung in der Photonik (z.B. Wellenleiter, Modulatoren, etc.) und auch Elektronik (Transistoren)ermöglicht.

Im Stand der Technik bestehen derzeit mehrere Ansätze, welche die Zugdehnung in Germanium oder anderen Materialien einstellen. Dies dient nicht immer der Veränderung der Bandstruktur (Bandstructure engineering), sondern teilweise auch der Messung der Zugdehnungseigenschaften von Metallen oder Isolatoren.
- Schnelles thermisches Anlassen (Rapid thermal annealing)
   Unter Temperaturveränderungen von zwei miteinander verbundenen Materialien entstehen Dehnungen aufgrund der unterschiedlichen Ausdehnungskoeffizienten. Letzteres ist von Bimetallelementen bekannt. Beides kann zur Einstellung eines Dehnungszustandes genutzt werden und ist zum Beispiel der Mechanismus zur Zugdehnungserhöhung in den bis anhin gezeigten Germanium-Lasern. Allerdings kann diese Methode bis heute nicht genügend Dehnung erzeugen, um durch Zugdehnung alleine eine direkte Bandlücke in Germanium erzeugen zu können.
- Wachstumsspannung bei epitaktischer Abscheidung:
   Bei Abscheidung eines Materials auf einem Substrate entstehen Wachstumsdehnungen aufgrund der unterschiedlichen Gitterkonstanten der beteiligten Materialien. Die Abscheidung von Germanium auf Silizium führt im Allgemeinen zu einer Druckverspannung, da die Gitterkonstante von Germanium 4.2% grösser ist als diejenige im Silizium. Umgekehrt führt die Abscheidung von Si auf Germanium zu einer Zugdehnungsverspannung diesmal vom Silizium. In einem aufwendigen Prozess-Verfahren (Smart-Cut) werden solche Silizumschichten vom Ge losgelöst und unter Beibehaltung der Verspannung auf ein Silizium Substrat mit Oxide (Si02) Deckschicht übertragen. Dies sind sogenannte strained silicon on insulator (SSOI) Strukturen. Das Oxid dient im weiteren zur elektrischen Isolation und ermöglicht die Fabrikation von mehrseitig freistehenden Silizium-Nanodrähten, was letztendlich zu weiteren Verbesserungen der Schaltgeschwindikeiten und der Leckstrom-Unterdrückung von Transistoren auf integrierten C-MOS Schaltkreisen führt. Prinzipiell kann mit dieser Methode das Silizium soweit verspannt werden bis die Gitterkonstante vom Ge (4.2%) erreicht wird. In der Praxis erzeugten Spannungen sind jedoch unter 1 %. Der limitierende Faktor ist die mit Spannung zunehmende Versetzungsdichte.
- Aktuatoren und Proben
   Ein weiter Ansatz ist im Feld der Materialcharakterisierung zu finden. Dabei wird ein Aktuator-Material, welches eine vorverspannte Zugdehnung aufweisen muss, auf einem Substrat aufgebracht, ist von diesem aber durch eine Opferschicht (sacrificial layer) getrennt. Das Probenmaterial wird zwischen Aktuator und einem feststehendem Punkt aufgebracht. Beim Loslösen des Aktuators und der Probe vom Substrat, durch Auflösen der Opferschicht, wird der Aktuator entspannt und somit die Probe zugverspannt. Somit hat man eine Mikro-Zugversuchsmaschine. Hier hat man mindestens vier beteiligte Materialien und muss gute Verbindungen, besonders für die laterale Verbindung von Probe und Aktuator gewährleisten. Auch ist der Aufbau wesentlich komplizierter (vgl. WO 2004/089811 A1).
- Gebogene Stege und Schichten
   Durch Einbetten von einer Probenschicht in unterschiedlich vor-verspannten Schichten, und anschließendem Loslösen dieses Verbundes vom Substrat kann eine Zugdehnung in der Probenschicht erzeugt werden. Auch dieser Ansatz ist verwandt mit dem Bimetall.
- Dehnung durch externe Kräfte
   Eine weitere Klasse von Methoden zum Einbringen von Zugdehnung ist die Nutzung von externen Kräften. So kann ein Probenmaterial gedehnt werden, wenn es auf eine Membran aufgebracht wird, und diese Membran durch Druck gedehnt wird. Auch gibt es Ansätze, wo Brücken und/oder Stegen durch mechanische Kräfte (z.B. Mittels AFM Spitze) und/oder elektromagnetische Kräfte (z.B. kapazitiv) gebogen werden, und somit Zugdehnung erfahren.

Der vorliegenden Erfindung liegt daher die Aufgabe zugrunde, eine Halbleiterkomponente und ein Verfahren zu dessen Herstellung anzugeben, mit denen es ermöglichst ist, die erforderlichen Zugspannungswerte bereitzustellen um die Eigenschaften des Siliziums und des Germaniums in die Richtung auf die Ausbildung von direkten Bandlücken resp. auf die Erzielung einer möglichst hohen Elektronenmobilität zu verschieben.

Diese Aufgabe wird erfindungsgemäss durch eine Halbleiterkomponente mit einem Substrat und einer von dem Substrat losgelösten, freistehenden Brückenstruktur gelöst, bei der ein für eine Funktionalität der Halbleiterkomponente relevanter Dehnungszustand durch eine Querschnittsmodulation in der von dem Substrat losgelösten, frei stehenden und beidseitig angebundenen Brückenstruktur in einer vorverspannten Schicht auf dem Substrat vorgesehen ist.

Die Erfindung ermöglicht das Einstellen eines Zugdehnungszustandes, der die Probleme des jetzigen Standes der Technik eliminiert. Gemäss dem erfindungsgemässen Verfahren wird dazu eine bereits vor-verspannte (Zugdehnung) Schicht, die auf einem Substrat aufgebracht ist, benutzt. In diese Schicht werden Brückenstrukturen mittels Lithographie und Ätzverfahren eingebracht. Diese Brücken sind an beiden Enden mit der Schicht und dem darunter liegenden Substrate verbunden und sind somit durchgängig. Ihre geometrische Form ist durch die Lithographie und durch das Ätzen bestimmten Fenster in der vorverspannten Schicht bestimmt. Die Brücken weisen eine Querschnittsmodulation auf. Wenn das Substrat selektiv geätzt wird, wird die Brücke durch die Fenster unterätzt und löst sich vom Substrat. Die geometrische Strukturierung des Querschnitts bewirkt eine Neuverteilung der ursprünglich homogenen Dehnung, sobald die auf diese Weise strukturierten Brücken vom Substrat gelöst werden. Dabei entspannen sich die Brückenteile mit großem Querschnitt auf Kosten der Teile mit kleinerem Querschnitt. Dieser Prozess führt dann zu der gewünschten drastischen Erhöhung der Vorverspannung in den zentralen Teilen der Brücke (im dünnen Teil der Brücke) .

Auf diese Weise lassen sich hantelförmige Brückenstrukturen erzeugen, die im englischsprachigen als "dumbbell bridge structures" bezeichnet werden. Es sei angemerkt, dass nur eine Multiplikation von ursprünglich in der Schicht vorhandenen Spannungen (resp. Dehnungen) möglich ist. Der Multiplikationsfaktor ist im Einzelnen bestimmt durch Längen, Breiten und Tiefen, respektive deren Verhältnisse in der Brückenstruktur. Effektiv erfährt die Brückenstruktur eine Dehnung- resp. Spannungsmodulation durch Querschnittsmodulation, wobei lokale Entspannung und lokale Verspannungen aus der homogenen und "globalen" Vorverspannung resultieren. Mit der hier beschriebenen Methode sind daher im Prinzip beliebige lokale Erhöhungen und Erniedrigungen der Vorverspannung möglich. Das Modulationsprofil der Dehnung entlang der Brücke hängt nur von der Vorverspannung, der Geometrie und des Grades der Unterätzung ab.

In einer vorteilhaften Ausgestaltung der vorliegenden Erfindung kann als Brückenstruktur Germanium auf einem Silizium-Substrat und/oder als Brückenstruktur Silizium oder Germanium auf einem Isolator-Substrat, wie z.B. SOI, resp. Germanium auf Insulator (GOI), vorgesehen sein, wodurch ein Laser für eine monolithische Integration in eine die Halbleiterkomponente umgebende Silizium-Architektur realisierbar ist. Diese Realisierung stellt eine komplette Neuerung in Silizium-basierter CMOS-Technologie dar. Dies gilt ebenfalls in vorteilhafter Ausgestaltung der vorliegenden Erfindung für eine vorverspannte Silizium und/oder Germanium-Schicht auf einem Isolator-Substrat, wodurch eine Transistor-Struktur mit einem verspanntem Leitungskanal realisiert ist. Dieser Leitungskanal weist nun mehr eine Elektronenbeweglichkeit auf, die der Beweglichkeit von Elektronen in Halbleitern mit direkter Bandlücke entspricht.

In einer bevorzugten Ausgestaltung der vorliegenden Erfindung kann auch eine Leiterplatten, wie z.B. ein Printed Curcuit Boards PCBs, und/oder ein integrierter Schaltkreise vorgesehen sein, welche als Substrat eine strukturierte Probenschicht mit darauf basierender Dehnungsmodulation aufweisen.

Zur Einstellung der gewünschten physikalischen Eigenschaften des besonders stark zugverspannten Abschnitts der vorverspannten Probenschicht kann die Brückenstruktur und eine unterhalb der Brückenstruktur erzielte Fensterstruktur über eine Dickenmodulation verfügen, die abgerundete Ecken an der Brückenstruktur und/oder der Fensterstruktur aufweist.

In einer weiteren vorteilhaften Weiterbildung der vorliegenden Erfindung kann das Material der Brücken-Struktur und des Substrats unabhängig von seiner kristallographischen Ausrichtung Mehrschichtsysteme umfassen.

Aufgrund der erzielbaren Zugdehnung kann die Halbleiterkomponente nun auch als Multiquantumwell (MQW) Modulator oder als Quantenkaskadenlaser (QKL) ausgeführt sein, was ebenfalls bisher in herkömmlicher CMOS-Si-Technologie nicht realisierbare Ausführungsformen darstellt.

Es ist weiter anzumerken, dass die vorliegende Erfindung extrem hohe Freiheitsgrade bezüglich der ausgestaltbaren physikalischen Eigenschaften der Halbleiterkomponente bietet. Seine Funktionalität, die durch seine nichtlinearen optischen Eigenschaften und/oder seine Doppelbrechung und/oder seine dielektrischen Eigenschaften und/oder seine elektrische Eigenschaften und/oder seine Bandstruktur und/oder seine ferroelastische Eigenschaft begründet ist, kann mit dem entsprechend eingestellten Dehnungszustand erzielt werden.

Weitere vorteilhafte Ausgestaltungen der vorliegenden Erfindung können den übrigen Unteransprüche entnommen werden.

Bevorzugte Ausführungsbeispiele der vorliegenden Erfindung werden anhand einer Zeichnung näher erläutert. Dabei zeigen:

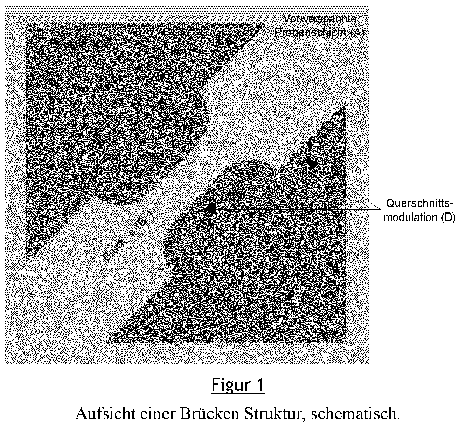

Figur 1 in schematischer Darstellung eine erste Brückenstruktur mit einer Querschnittsmodulation;

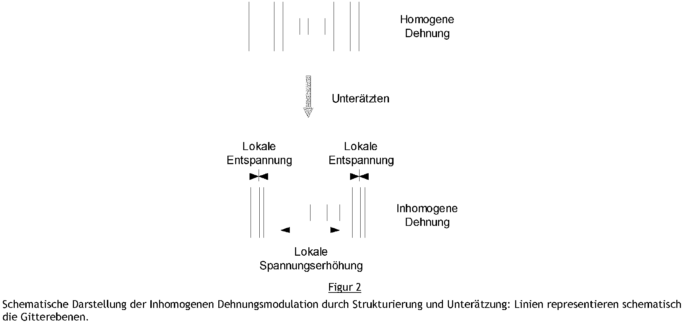

Figur 2 in schematischer Darstellung der inhomogenen Dehnungsmodulation durch Strukturierung und Unterätzung, Linien repräsentieren schematisch die Gitterebenen;

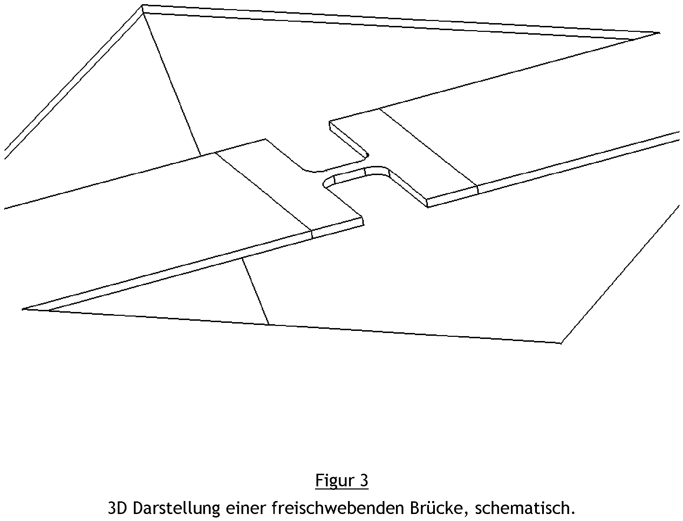

Figur 3 In schematischer 3D Darstellung, eine unterätzten Brückenstruktur; und
Figur 4 die Dehnungsmodulation einer Brückenstruktur gemessen mittels einer Raman-Spektroskopie.

Ein bevorzugtes Ausführungsbeispiel, an dem das Funktionieren der Erfindung demonstrierbar ist, besteht aus zug-verspannten Germanium auf einem Silizium-Substrat. Das Germanium wurde durch Low Energy Plasma Enhanced Chemical Vapor Deposition aufgebracht. Die Fenster wurden durch E-Beam Lithography definiert und in eine PMMA-Maske geschrieben. Nach der Entwicklung der PMMA-Schicht wird mittels Cl₂-Gas die Maske in eine Cr-Schicht zwischen PMMA und Germanium-Schicht übersetzt. Durch reaktives Ionen-Ätzen (z.B. ICP-RIE DRIE (Deep Reactive Ion Etching) Prozess mit CHF₃ und SF₆) wird die Fensterstruktur in das Germanium eingebracht. Das Loslösen von der Brücke erfolgt durch selektives Unterätzten mittels Kaliumhydroxidlösung bei 80°C und 20w%.

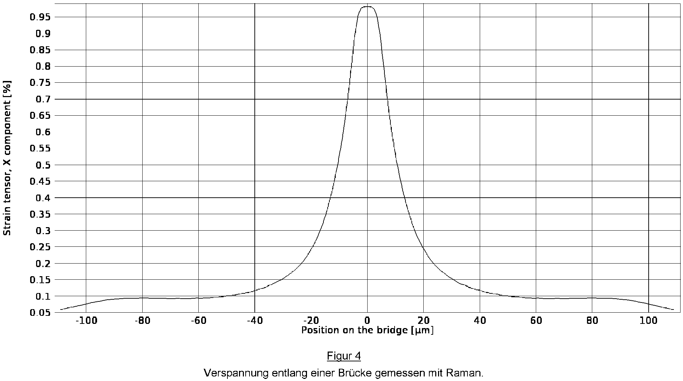

Es wurden verschiedene Prozessführungen versucht, von denen hier nur die besonders bevorzugte Prozessführung wiedergegeben ist. Unabhängig davon sind die verschiedenen Ansätze, einschliesslich Alternativen, in den Ansprüchen abgedeckt. Die Brücken, sowie ihr freies Stehen, wurden mittels Rasterelektronenmikroskopie verifiziert und die Dehnungsmodulation durch Ramanspektroskopie (Figur 4) bestätigt.

Eine alternatives Ausführungsbeispiel betrifft verspanntes Silizium auf Oxid (SSOI). Hier werden die entsprechenden Fenster ins Silizium eingebracht; wiederum mittels reaktivem Ionen-Ätzen. Das Loslösen der Brücken erfolgt in unserem Beispiel durch isotrop ätzende Salzsäure (HCL), was nur das Oxid angreift und so die entsprechende Silizium-Brücke freiätzt. Bei Brücken, die entlang einer bestimmten kristallographischen Richtung ausgerichtet sind, ist die Verspannung einachsig (uniaxial). Dies ist die bevorzugte Verspannung zur Beweglichkeitsverbesserung. Isotropes Ätzen ermöglicht Brücken herzustellen, die beliebig ausgerichtet oder auch gekrümmt sind. Dies ermöglicht lokale und selektive Bandstruktur-Modulationen im Leitungsband und Valenzband, was zum Beispiel zu Ladungstrennung führen kann, was ausgenützt werden könnte zur Herstellung von effizienteren Solarzellen oder Lichtdetektoren. Die Leitungs- und Valenzband selektive Bandstruktur-Modulation könnte auch genutzt werden um Löchermit Elektron basierten Transistoren zu funktionellen Schaltkreisen zu.

Eine weiteres alternatives Ausführungsbeispiel betrifft zweiachsig (biaxial) in typischerweise zwei orthogonalen Richtungen verspannte Brücken. Bandstruktur-Effekte können dabei weiter verstärkt werden. Ebenso ist es möglich, Mehrfach-Brücken herzustellen. Dabei verteilt sich die Verspannung gleichförmig auf die parallel angeordneten Brücken. In Brücken, dimensioniert im Nanometerbereich, können so vorteilhafte Quanten-Effekte auftreten. Dissipative Prozesse, bedingt durch Elektronen-Streuung, könnten effektiv unterdrückt werden dank eindimensionalem Elektronen Transport.

## Patentansprüche

1. Halbleiterkomponente mit einem Substrat und einer von dem Substrat losgelösten, freistehenden Brückenstruktur, bei der ein für eine Funktionalität der Halbleiterkomponente relevante Dehnungszustand durch eine Querschnittsmodulation in der von dem Substrat losgelösten, frei stehenden und beidseitig angebundenen Brückenstruktur in einer vorverspannten Schicht auf dem Substrat vorgesehen ist.

2. Halbleiterkomponente nach Anspruch 1,
**dadurch gekennzeichnet, dass**
als Brückenstruktur Germanium auf einem Silizium-Substrat und/oder als Brückenstruktur Silizium oder Germanium auf einem Isolator-Substrat, wie z.B. SOI, resp. GOI, vorgesehen sind, wodurch ein Laser für eine monolithische Integration in eine die Halbleiterkomponente umgebende Silizium-Architektur realisiert ist.

3. Halbleiterkomponente nach Anspruch 1,
**dadurch gekennzeichnet, dass**
eine vorverspannte Silizium und/oder Germanium-Schicht auf einem Isolator-Substrat vorgesehen ist, wodurch eine Transistor-Struktur mit einem verspanntem Leitungskanal realisiert ist.

4. Halbleiterkomponente nach einem der Ansprüche 1 bis 3,
**dadurch gekennzeichnet, dass**
eine Leiterplatten, wie z.B. ein Printed Curcuit Boards PCBs, und/oder ein integrierter Schaltkreise vorgesehen sind, welche als Substrat eine strukturierte Probenschicht mit darauf basierender Dehnungsmodulation aufweisen.

5. Halbleiterkomponente nach einem der Ansprüche 1 bis 4,
**dadurch gekennzeichnet, dass**
die Brückenstruktur und eine unterhalb der Brückenstruktur erzielte Fensterstruktur über eine Dickenmodulation verfügen, die abgerundete Ecken an der Brückenstruktur und/oder der Fensterstruktur aufweist.

6. Halbleiterkomponente nach einem der Ansprüche 1 bis 5,
**dadurch gekennzeichnet, dass**
das Material der Brücken-Struktur und des Substrats unabhängig von seiner kristallographischen Ausrichtung Mehrschichtsysteme umfasst.

7. Halbleiterkomponente nach einem der Ansprüche 1 bis 6,
**dadurch gekennzeichnet, dass**
die Halbleiterkomponente Multiquantumwell (MQW) Modulator oder als Quantenkaskadenlaser (QKL) ausgeführt ist.

8. Halbleiterkomponente nach einem der Ansprüche 1 bis 7,
**dadurch gekennzeichnet, dass**
seine Funktionalität durch seine nichtlinearen optischen Eigenschaften und/oder seine Doppelbrechung und/oder seine dielektrischen Eigenschaften und/oder seine elektrische Eigenschaften und/oder seine Bandstruktur und/oder seine ferroelastische Eigenschaft mit dem eingestellten Dehnungszustand erzielt ist.

9. Verfahren zur Herstellung einer Halbleiterkomponenten, unter Benützung einer bereits vor-verspannte auf einem Substrat aufgebrachten (Zugdehnungs-)Schicht, insbesondere nach einem der Ansprüche 1 bis 8, **gekennzeichnet durch** die folgenden Verfahrensschritte:
a) in diese vor-verspannte (Zugdehnungs-)Schicht wird eine Brückenstruktur mittels Lithographie und Ätzverfahren eingebracht, wobei diese Brückenstruktur an beiden Enden mit der vor-verspannten Schicht und dem darunter liegenden Substrate verbunden und somit durchgängig sind, und wobei die geometrische Form der Brückenstruktur **durch** die lithographisch und **durch** das Ätzen bestimmten Fenster in der vorverspannten Schicht bestimmt ist und wobei ferner die Brückenstruktur eine Querschnittsmodulation aufweist;
b) mittels eines selektiven Ätzens des Substrats wird die Brückenstruktur **durch** die Fenster unterätzt, wobei die geometrische Strukturierung des Querschnitts entlang der Brückenstruktur eine Neuverteilung der ursprünglich homogenen Dehnung auslöst, sobald die auf diese Weise strukturierte Brückenstruktur vom Substrat gelöst worden ist;
c) infolge dieses Loslösens entspannen sich dabei die Teile der Brückenstruktur mit großem Querschnitt auf Kosten der Teile mit kleinerem Querschnitt, was zu einer gewünschten drastischen Erhöhung der Vorverspannung in den zentralen Teilen der Brückenstruktur, in der Regel in den dünnen Teilen der Brückenstruktur, führt.
